# EUROPÄISCHE PATENTSCHRIFT

(11) **EP 0 607 843 B1**
(45) Veröffentlichungstag und Bekanntmachung des Hinweises auf die Patenterteilung: **11.10.1995**
(21) Anmeldenummer: 94100303.0
(22) Anmeldetag: 11.01.1994
(51) Int. Cl.: H05K 9/00

(54) **Einstückiges Isolierteil, insbesondere Spritzgiessteil**
One piece insulating part, especially injection molded part
Elément isolant en une pièce, en particulier une pièce fait par moulage par injection

(30) Priorität: 22.01.1993 DE 9300868 U
(43) Veröffentlichungstag der Anmeldung: 27.07.1994
(73) Patentinhaber: SIEMENS AKTIENGESELLSCHAFT, 80333 München (DE)
(72) Erfinder: Schönberger, Eduard, Dipl.-Ing. (FH), D-92245 Kümmersbruck (DE); Gruber, Stefan, Dipl.-Ing. (FH), D-92245 Kümmersbruck (DE); Kasowski, Hermann, Dipl.-Ing. (FH), D-92280 Kastl (DE); Schmidt, Heinz, Dipl.-Ing. (FH), D-92245 Kümmersbruck (DE)

(56) Entgegenhaltungen:
- EP-A- 0 306 412
- DE-A- 3 325 360
- US-A- 5 107 404

## Beschreibung

Die vorliegende Erfindung betrifft ein Isolierteil gemäß dem Oberbegriff des Anspruchs 1. Ein derartiges Isolierteil ist beispielsweise aus der EP 0 465 692 A1 bekannt. Auch beim Automatisierungsgerät SIMATIC S5-95 U der Siemens AG wird ein derartiges Isolierteil als Gehäuserückwand verwendet.

Bei Verwendung höherer Spannungen, z.B. 230 V, ist es nötig, die Leiterzüge relativ weit voneinander entfernt anzuordnen, damit vorgeschriebene Spannungsabstände zwischen benachbarten Leiterbahnen und Lötaugen eingehalten werden. Der Schaltungsträger kann daher aufgrund elektrischer Sicherheitsvorschriften nur zu einem erheblich geringeren Maß ausgenützt werden als bestückungstechnisch bzw. leiterbahntechnisch möglich wäre. Eine Aufgabe der vorliegenden Erfindung besteht folglich darin, eine Möglichkeit zu schaffen, Bauelemente, Leiterbahnen und Lötaugen näher aneinander anzuordnen und so den zur Verfügung stehenden Platz besser auszunützen.

Weiterhin stellt sich bei elektronischen Baugruppen das Problem der elektrischen Schirmung, sei es bezüglich emittierter oder immittierter elektromagnetischer Störstrahlung. Eine zweite Aufgabe der vorliegenden Erfindung besteht also darin, eine Möglichkeit zur einfachen Schirmung von Baugruppen bzw. Baugruppenteilen zu schaffen.

Die erste Aufgabe wird dadurch gelöst, daß das Isolierteil zwischen den Leiterzügen eine Erhebung, z.B. eine Rippe, und/oder eine Vertiefung, z. B. ein Rinne, mit den Leiterzügen zugewandten Leiterzugseiten aufweist, wobei die Erhebung frei von elektrisch leitenden Beschichtungen ist. Dadurch wird nämlich der wirksame Abstand zwischen zwei Leiterzügen beträchtlich erhöht, so daß der direkte Abstand zwischen den Leiterzügen ohne Sicherheitseinbußen verringert werden kann.

Die zweite Aufgabe wird dadurch gelöst, daß das Isolierteil zwischen den Leiterzügen eine Erhebung, z.B. eine Rippe mit den Leiterzügen zugewandten Leiterzugseiten aufweist, wobei mindestens eine der Leiterzugseiten eine elektrisch leitende Beschichtung aufweist. Durch die elektrisch leitende Beschichtung wird nämlich eine Abschirmung der beiden Leiterzüge bzw. der auf den beiden Leiterzügen angeordneten Bauelemente bzw. allgemein der durch die Erhebung voneinander getrennten Gebiete der Isolierteilseite voneinander erreicht.

Weitere Vorteile und Einzelheiten ergeben sich aus der nachfolgenden Beschreibung eines Ausführungsbeispiels, anhand der Zeichnungen und in Verbindung mit den weiteren Unteransprüchen. Dabei zeigen:
- FIG 1: ein Kunststoffteil mit unbeschichteten Erhebungen,
- FIG 2: ein Kunststoffteil mit elektrisch leitend beschichteten Erhebungen und
- FIG 3: ein Detail einer Erhebung.

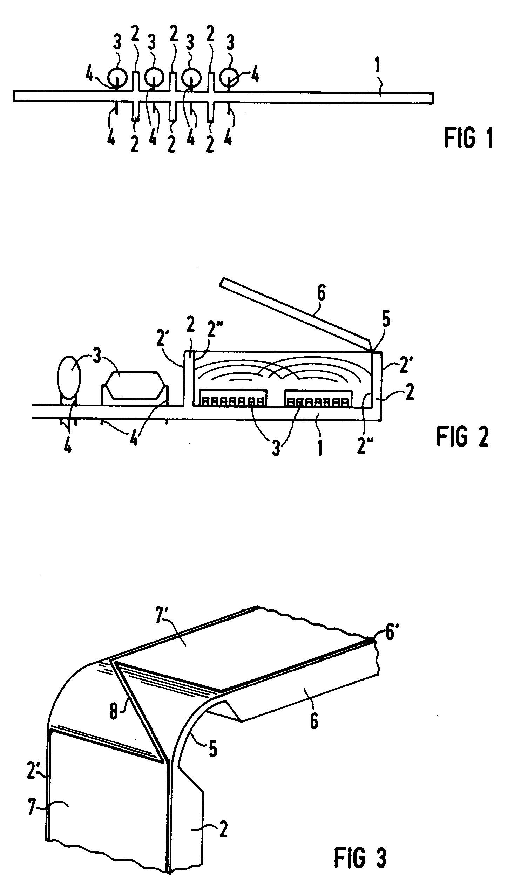

Gemäß FIG 1 weist das einstückige Spritzgießteil 1 mehrere längliche Rippen 2 auf, zwischen denen elektronische Bauelemente 3, z. B. Widerstände, Lötaugen und Leiterzüge 4 verlaufen. Die Rippen 2 sind frei von elektrisch leitenden Beschichtungen. Dadurch wird der wirksame Abstand zwischen benachbarten Bauelementen 3 bzw. benachbarten Leiterzügen 4, vergrößert, so daß trotz Betrieb der Schaltung mit einer hohen Spannung, z. B. 230 Volt, die Leiterzüge 4 und die Bauelemente 3 nah aneinander angeordnet werden können.

Anstelle einer nicht metallisch beschichteten Rippe 2 kann auch eine nicht metallisch beschichtete Rinne zwischen den Leiterzügen 4 angeordnet sein, da die vorgeschriebene Luftstrecke erheblich kleiner als die vorgeschriebene Kriechstrecke ist.

Auch das Spritzgießteil 1 gemäß FIG 2 ist einstückig ausgebildet und weist Rippen 2 auf. Die Rippe 2 weist auf mindestens einer der Leiterzugseiten 2′, 2˝, eine elektrisch leitende Beschichtung auf, z. B. auf der Leiterzugseite 2′. Mittels dieser Beschichtung wird die zwischen den Rippen 2 befindliche Schaltung von ihrer Umgebung abgeschirmt.

Die Abschirmung ist besonders gut, wenn sie allseitig erfolgt. Hierzu weist das Spritzgießteil eine umlaufende Rippe 2 auf, wie in FIG 2 dargestellt, so daß die Rippe 2 die Seitenwände eines Kastens bildet. Über eine Verjüngung 5 ist ein Deckel 6 mit der Rippe 2 verbunden, der den Kasten oben abschließt. Der Boden des Kastens wird durch die Grundfläche des Kunststoffteils 1 selbst gebildet.

Gemäß FIG 3 sind sowohl die Außenseite 2′ der Rippe 2 als auch die Außenseite 6′ des Deckels 6 großflächig mit Metallbeschichtungen 7, 7′ versehen. Die Beschichtungen 7, 7′ sind durch einen diagonal über die Verjüngung 5 verlaufenden Leiterzug 8 miteinander verbunden. Durch die diagonale Verbindung der Beschichtungen 7, 7′ wird erreicht, daß bei einem Betätigen des Deckels 6 der Leiterzug 8 nicht unterbrochen wird, was geschehen könnte, wenn der Leiterzug 8 die Beschichtungen 7, 7′ auf dem kürzestmöglichen Weg miteinander verbinden würde. Alternativ zu dem diagonal verlaufenden Leiterzug 8 kann die Verjüngung 5 jedoch auch voll metallisiert sein.

Abschließend sei darauf hingewiesen, daß das Spritzgießteil 1 zunächst in bekannter Weise spritzgegossen wird und sodann in ebenfalls bekannter Weise großflächig metallisch beschichtet wird. Die Leiterzüge 4, 8 sowie die unbeschichteten Elemente entstehen durch Entfernen der Metallschicht an den Stellen, an denen die Metallschicht unerwünscht ist.

Ferner kann anstelle eines Spritzgießteils auch ein anderer einstückiger, auf seiner Oberfläche zunächst elektrisch isolierender Schaltungsträger verwendet werden, z. B. ein auf seiner gesamten Oberfläche in geeigneter Weise eloxiertes Aluminium-Druckgußteil.

## Patentansprüche

1. Einstückiges Isolierteil, z. B. Kunststoffteil, insbesondere Spritzgießteil, mit mindestens einer Kunststoffteilseite, auf der mindestens zwei Leiterzüge angeordnet sind,
**dadurch gekennzeichnet,** daß das Kunststoffteil (1) zwischen den Leiterzügen (4) eine Erhebung (2), z. B. eine Rippe (2) und/oder eine Vertiefung, z. B. eine Rinne, mit den Leiterzügen (4) zugewandten Leiterzugseiten (2′,2˝) aufweist.

2. Isolierteil nach Anspruch 1, **dadurch gekennzeichnet,** daß die Erhebung (2) frei von elektrisch leitenden Beschichtungen ist.

3. Isolierteil nach Anspruch 1, **dadurch gekennzeichnet,** daß mindestens eine Leiterzugseite (2′) eine elektrisch leitende Beschichtung (7) aufweist.

4. Isolierteil nach Anspruch 3, **dadurch gekennzeichnet,** daß die Erhebung (2+6) eine mit der Kunststoffteilseite direkt verbundene Basiserhebung (2) und eine Zusatzerhebung (6) aufweist, wobei die Zusatzerhebung (6) über eine als Filmscharnier wirkende Verjüngung (5) mit der Basiserhebung (2) verbunden ist.

5. Isolierteil nach Anspruch 4, **dadurch gekennzeichnet,** daß die Basiserhebung (2) und die Zusatzerhebung (6) je eine großflächige elektrisch leitende Beschichtung (7,7′) aufweisen und daß die Beschichtungen (7,7′) über einen diagonal über die Verjüngung (5) verlaufenden Leiterzug (8) miteinander verbunden sind.

6. Isolierteil nach einem der obigen Ansprüche, **dadurch gekennzeichnet,** daß es als mit einer Isolierschicht versehenes Metallteil, z. B. als eloxiertes Aluminium-Druckgußteil, ausgebildet ist.

## Claims

1. One-piece insulating part, for example plastics part, in particular injection-moulded part, having at least one plastics part side on which at least two printed conductors are arranged, characterised in that the plastics part (1) between the printed conductors (4) has an elevation (2), for example a rib (2), and/or a depression, for example a groove, with printed conductor sides (2′, 2˝) facing the printed conductors (4).

2. Insulating part according to claim 1, characterised in that the elevation (2) is free of electrically conductive coatings.

3. Insulating part according to claim 1, characterised in that at least one printed conductor side (2′) has an electrically conductive coating (7).

4. Insulating part according to claim 3, characterised in that the elevation (2+6) has a base elevation (2), which is directly connected with the plastics part side, and an additional elevation (6), with the additional elevation (6) being connected with the base elevation (2) by way of a tapered portion (5) which acts as a film hinge.

5. Insulating part according to claim 4, characterised in that the base elevation (2) and the additional elevation (6) each have a coating (7, 7′) which is electrically conductive over a large area and in that the coatings (7, 7′) are connected with each other by way of a printed conductor (8) which extends diagonally across the tapered portion (5).

6. Insulating part according to one of the above claims, characterised in that it is formed as a metal part, for example as an anodized aluminium die-cast part, which is provided with an insulating layer.

## Revendications

1. Pièce isolante monobloc, par exemple pièce en matière plastique, notamment pièce moulée par injection, comportant au moins une face sur laquelle sont disposées au moins deux voies conductrices, caractérisée par le fait que la pièce en matière plastique (1) comporte, entre les voies conductrices (4), une partie surélevée (2), par exemple une nervure (2) et/ou un renfoncement, par exemple une rainure, comportant des faces (2′,2˝) tournées vers les voies conductrices (4).

2. Pièce isolante suivant la revendication 1, caractérisée par le fait que la partie surélevée (2) ne comporte aucun revêtement électriquement conducteur.

3. Pièce isolante suivant la revendication 1, caractérisée par le fait qu'au moins une face (2′) tournée vers les voies conductrices porte un revêtement électriquement conducteur (7).

4. Pièce isolante suivant la revendication 3, caractérisée par le fait que la partie surélevée (2+6) possède une partie surélevée de base (2), qui est reliée directement à la face de la pièce en matière plastique, et une partie surélevée supplémentaire (6), la partie surélevée supplémentaire (6) étant reliée à la partie surélevée de base (2) par l'intermédiaire d'une partie amincie (5) agissant comme charnière en forme de pellicule.

5. Pièce isolante suivant la revendication 4, caractérisée par le fait que la partie surélevée de base (2) et la partie surélevée supplémentaire (6) possèdent chacune un revêtement électriquement conducteur de surface étendue (7,7′) et que les revêtements (7,7′) sont reliés entre eux par l'intermédiaire d'une voie conductrice (8) qui s'étend en diagonale sur la partie amincie (5).

6. Pièce isolante suivant l'une des revendications précédentes, caractérisée par le fait qu'elle est réalisée sous la forme d'une pièce métallique pourvue d'une couche isolante, par exemple sous la forme d'une pièce coulée sous pression en aluminium anodisé.
